# EUROPEAN PATENT SPECIFICATION

(11) **EP 0 829 140 B1**
(45) Date of publication and mention of the grant of the patent: **25.06.2003**
(21) Application number: 97904549.9
(22) Date of filing: 04.03.1997
(51) Int. Cl.: H03K 19/177

(54) **A PROGRAMMABLE LOGIC DEVICE**
PROGRAMMIERBARE LOGISCHE VORRICHTUNG
DISPOSITIF LOGIQUE PROGRAMMABLE

(30) Priority: 28.03.1996 US 623622
(43) Date of publication of application: 18.03.1998
(73) Proprietor: Xilinx, Inc., San Jose, California 95124-3400 (US)
(72) Inventor: SHIMANEK, Schuyler, E., NL-5656 AA Eindhoven (NL); DAVIES, Thomas, J., NL-5656 AA Eindhoven (NL)
(74) Representative: Freeman, Jacqueline Carol
(86) International application number: PCT/IB97/00195
(87) International publication number: WO 97/036374

(56) References cited:
- EP-A- 0 051 157
- EP-A- 0 109 777
- EP-A- 0 376 905
- WO-A-96/10295
- US-A- 5 235 221

## Description

The basic building blocks of a programmable logic device (PLD) are the Product-term and the OR-term. Within each of these "terms" exist several programmable logic blocks (cells). When the outputs of several such cells are "ANDed" the term is called a "Product-term", and when the outputs are "ORed" the term is called an "OR-term."

A basic PLD can have the architecture of a PAL (a trademark of Monolithic Memories Inc. which stands for "Programmable Array Logic"). The construction of a PAL is made by stacking several product-terms and "ORing" sequential clusters of their outputs into a fixed width OR gate. A basic PLD can also have the architecture of a PLA (Programmable Logic Array), which is similar to that of the PAL, except that the output of each product term functions as an input to an array of OR-terms, instead of to a fixed width OR-gate.

In a PLA the stacked product terms form an array, in which respective product-terms form respective rows. An array of OR-terms is conventionally placed alongside the stack of product-terms, that is, in the area obtained by extending the rows. The PAL contains an array of product terms similar to the first array of the PLA. In the PAL the fixed width OR gates are similarly placed as the OR-terms in the PLA, but these OR gates generally occupy less space than the OR-terms in a PLA of comparable size.

When a PAL and a PLA are combined in a single PLD, in such a way that input lines are fed to both the product-terms in the PAL and the PLA, the arrays of product terms of both the PAL and the PLA are stacked, such that the array of product terms in the PAL is in the area extending perpendicularly to the rows of the array of product terms in the PLA. Because the fixed width OR gates in the PAL occupy less space than the OR-terms in the PAL, the combined PAL and PLA will thus have an L-shape when they are placed on silicon. This prevents efficient placement of multiple blocks of PLA-PAL combinations in complex Programmable Logic Devices. Under these circumstances, not only is silicon die space wasted, but decode routing is more complicated and propagation delay through the PLA become more skewed.

Amongst others, it is an object of the invention to provide a programmable logic device having a PLA plus PAL architecture in which the required die size is more compact.

It is another object of the invention to provide a programmable logic device having a PLA plus PAL architecture that utilizes simplified interconnect routing between the PAL, the PLA and the OR-terms.

It is yet another object of the invention to provide a programmable logic device with a PLA plus PAL architecture that has reduced propagation delay skews.

The invention provides for a programmable logic device comprising
a first array with first rows of first programmable logic blocks;
first means for forming a respective logic AND from outputs of the first programmable logic blocks in each respective first row;
a second array with second rows of second programmable logic blocks, the second rows running in parallel with the first rows;
second means for forming a respective logic AND from outputs of the second programmable logic blocks in each respective second row;
third rows of third programmable logic blocks, the third rows being located in the first array among the first rows, each third programmable logic block receiving a respective output of the first means;
third means for forming a respective logic OR from outputs of the third programmable logic blocks in each respective third row;
logic means for forming respective logic combinations of outputs of the second and third means. In this way, the OR-terms of a PLA can be interleaved between the Product-terms of a PAL array. That is, rather than routing the outputs of the Product-terms of the PLA array into the area obtained by extending the rows of the first array, these outputs are routed in a transversal direction through both the first and second array. In this way valuable die space is conserved and decode routing to the programmable logic blocks is simplified.

### BRIEF DESCRIPTION OF THE DRAWINGS

Other objects and features of the present invention will become apparent from the following detailed description considered in connection with the accompanying drawings which disclose an embodiment of the present invention. It should be understood, however, that the drawings are designed for the purpose of illustration only and not as a definition of the limits of the invention.

In the drawings, wherein similar reference characters denote similar elements throughout the several views:
FIG. 1 is a block diagram of a PAL plus PLA architecture according to the prior art;
FIG. 2a is a block diagram of product-term programmable logic elements according to the invention;
FIG. 2b is a block diagram of ORterm programmable logic elements according to the invention;
FIG. 3 is block diagram of the psquare or condensed PAL plus PLA architecture according to the invention.

### DETAILED DESCRIPTION OF PREFERRED EMBODIMENTS

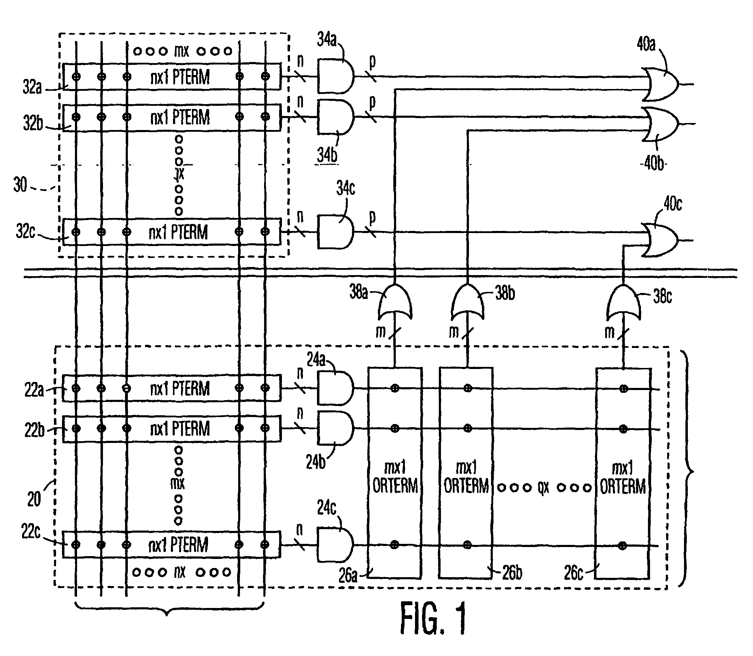

FIG. 1 shows a block diagram of a PAL plus PLA architecture according to the prior art. The PAL array 30 is situated above PLA array 20 in an L-shaped configuration. The PLA array 20 consists of Pterm elements 22a, 22b and 22c, arranged immediately under the Pterm elements 32a, 32b and 32c of PAL array 30. The outputs of Pterms 22a - 22c are ANDed via gates 24a, 24b, and 24c, respectively, and fed into ORterms 26a, 26b, and 26c.

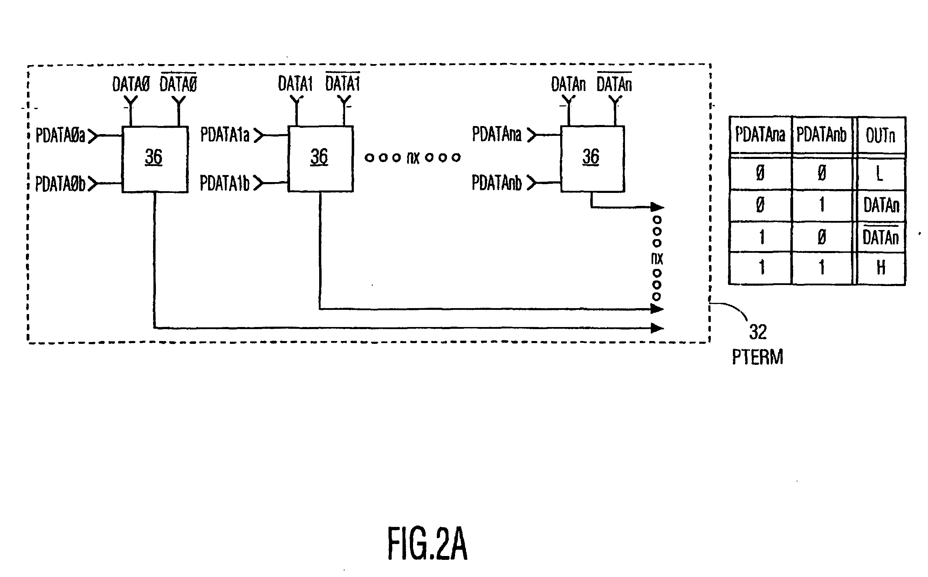

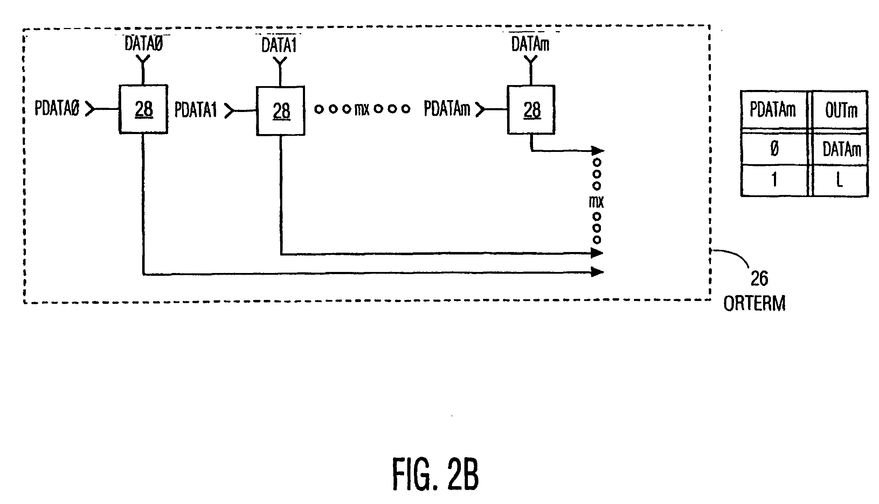

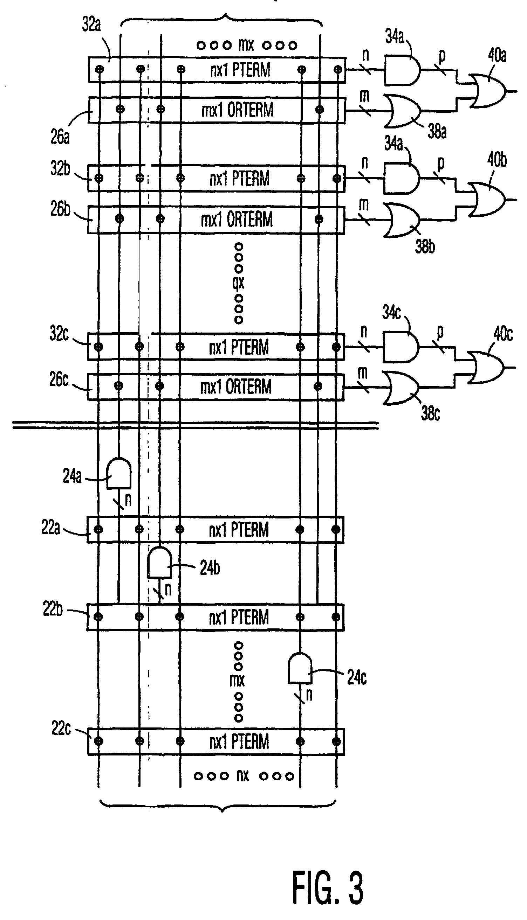

With the ORterms 26a-26c being arranged in this L-shaped configuration, the same basic shape results when situated on silicon, thus the efficient placement of multiple blocks of these arrays is not possible. In addition to the wasting of silicon die space, the decode routing required between the ORterms, the PLA array, and the PAL array is more complicated, and the propagation delays through the PLA path become more skewed. FIGS. 2a and 2b show block diagrams of the Product-term (Pterm) and ORterm logic elements 32 and 26, respectively. Pterm elements 32 also correspond to Pterm elements 22 in FIGS. 1 and 3. Within each of these terms exists several programmable logic blocks. For example, Pterm 32 consists of several programmable logic blocks 36, and ORterm 26 consists of several programmable logic blocks 28.

Pterms 36 each have two data inputs and two control inputs. The control inputs can also consist of memory element states. ORterms 28 each have one data input and one control input.

FIG. 3 shows the condensed single block PAL plus PLA (PSQUARE) architecture according to the invention. In this embodiment, the ORterms 26a, 26b and 26c are evenly distributed among the Pterms of the PAL array, thereby forming the PAL array + PLA OR group. With this configuration, the AND gates 24a-24c are relocated to within the PLA array. The outputs of AND gates 24a - 24c, of the Pterms 22a-22c, respectively, are fed vertically through both arrays into each of ORterms 26a-26c. Thus, the placement of the ORterms 26a-26c to the right of the PLA array is eliminated, and a significant amount of space is saved. This translates into a smaller die size needed to embody the circuit on silicon, and reduces the propagation delay skews associated with the interconnection of these elements.

The outputs of ORterms 26a-26c are fed into OR gates 38a-38c, respectively, and the outputs of the Pterms 32a-32c are fed into AND gates 34a-34c. The outputs of AND gate 34a and OR gate 38a are fed into OR gate 40a. The output of OR gate 40a feeds the macro cell being driven by this circuit. This same configuration applies for the remaining interleaved ORterms and Pterms.

By interleaving the PLA ORterms within the PAL Pterms, the outputs of the PLA array Pterms are connected vertically through both arrays to feed the rotated PLA ORterm inputs. This configuration simplifies the decode routing needed for this application. Since the PSQUARE architecture is a rectangular array, the advent of advanced integrated circuit techniques including multiple layers of metal, all programming decode routing and inter-array interconnection issues are solved without sacrificing valuable chip area. In an alternative embodiment of the invention (not shown), the PLA product terms can be interleaved within the PAL product terms. This accommodates even spacing of the macro cells along the entire length of PAL plus PLA array.

While only a single embodiment of the present invention has been shown and described, it is to be understood that many changes and modifications may be made thereunto without departing from the scope of the invention as defined in the appended claims. In summary, the invention provides for a condensed single block PLA plus PAL architecture. The architecture comprises at least one PLA array having a plurality of Pterm elements each having an input and an output, and a plurality of AND gates each having and output, and an input coupled to one of said plurality of outputs of said Pterm elements. The architecture furthermore comprises at least one PAL array coupled to said at least one PLA array, said at least one PAL array having a plurality of Pterm elements each having an input and an output, and a plurality of AND gates each having an output, and an input coupled to one of said plurality of outputs of said Pterm elements of said PAL array. A plurality of PLA ORterms is disposed within said Pterm elements of said PAL array, each of said PLA ORterms having an output, and inputs coupled to said outputs of said AND gates of said PLA array, and a plurality of OR gates each having an output, and an input coupled to the output of said PLA ORterms. A plurality of OR gates is provided, each having an output, and two inputs, one of said inputs for receiving one of the outputs of said AND gates of the PAL array, and the other of said inputs receiving the output of said OR gates of said PLA ORterms, the output of said OR gate feeds a macro cell circuit connected to the condensed single block PLA plus PAL circuit. In an embodiment of the condensed single block PLA plus PAL architecture the outputs of said AND gates connected to the Pterm elements of the PLA array are coupled to the PLA ORterms disposed among said PAL array Pterms through said PLA array and PAL array, said coupling enabling the condensed single block PAL plus PLA circuit to be embodied in a smaller die area. In a further embodiment of the condensed single block PLA plus PAL architecture the coupling of the PLA Pterms, via said AND gates, with the PLA ORterms within the PAL array reduces propagation delay skews of the PAL and PLA array.

## Claims

1. A programmable logic device comprising
a first array with first rows (22a...22c) of first programmable logic blocks;
first means (24a...24c) for forming a respective logic AND from outputs of the first programmable logic blocks in each respective first row;
a second array with second rows (32a...32c) of second programmable logic blocks, the second rows (32a...32c) running in parallel with the first rows (22a...22c);
second means (34a...34c) for forming a respective logic AND from outputs of the second programmable logic blocks in each respective second row;
third rows (26a...26c) of third programmable logic blocks, the third rows being located in the first array among the first rows (22a...22c), each third programmable logic block receiving a respective output of the first means;
third means (38a...38c) for forming a respective logic OR from outputs of the third programmable logic blocks in each respective third row;
logic means (40a...40c) for forming respective logic combinations of outputs of the second and third means.

2. A programmable logic device according to Claim 1, wherein said first and second arrays are arranged in a rectangular area on a semiconductor die, both along a first edge of said rectangular area, the first (22a...22c), second (32a...32c) and third (26a...26c) rows running perpendicular to the first edge.

3. A programmable logic device according to Claim 1 or 2 having a plurality of input lines, each coupled to a respective programmable logic block in each of the first and second rows.

4. A programmable logic device according to Claim 1, 2 or 3 comprising coupling lines between said first means (24a...24c) and said third rows (26a...26c).

5. A programmable logic device according to Claim 1, 2, 3 or 4 wherein the second rows (32a...32c) are organized in respective subsets, the respective logic combinations each being a logic OR of a respective output of the third means and a respective one of the subsets.

## Patentansprüche

1. Programmierbare Logikanordnung, umfassend:
eine erste Array mit ersten Reihen (22a ... 22c) erster programmierbarer Logikblöcke,
erste Mittel (24a ... 24c) zum Bilden einer jeweiligen logischen UND-Verknüpfung von Ausgängen der ersten programmierbaren Logikblöcke in jeder jeweiligen ersten Reihe;
eine zweite Array mit zweiten Reihen (32a ... 32c) von zweiten programmierbaren Logikblöcken, wobei die zweiten Reihen (32a... 32c) parallel zu den ersten Reihen (22a ... 22c) laufen;
zweite Mittel (34a ... 34c) zum Bilden einer jeweiligen logischen UND-Verknüpfung von Ausgängen der zweiten programmierbaren Logikblöcke in jeder jeweiligen zweiten Reihe;
dritte Reihen (26a ... 26c) von dritten programmierbaren Logikblöcken, wobei sich die dritten Reihen in der ersten Array unter den ersten Reihen (22a ... 22c) befinden, wobei jeder dritte programmierbare Logikblock einen jeweiligen Ausgang der ersten Mittel empfängt;
dritte Mittel (38a ... 38c) zum Bilden einer jeweiligen logischen ODER-Verknüpfung von Ausgängen der dritten programmierbaren Logikblöcke in jeder jeweiligen dritten Reihe;
Logikmittel (40a ... 40c) zum Bilden jeweiliger logischer Kombinationen von Ausgängen der zweiten und dritten Mittel.

2. Programmierbare Logikanordnung nach Anspruch 1, bei der die genannte erste und zweite Array in einem rechteckigen Bereich auf einem Halbleiterchip angeordnet sind, beide entlang eines ersten Randes des genannten rechteckigen Bereiches, wobei die erste (22a...22c), zweite (32a...32c) und dritte (26a ... 26c) Reihe lotrecht zum ersten Rand verlaufen.

3. Programmierbare Logikanordnung nach Anspruch 1 oder 2 mit einer Mehrzahl von Eingangsleitungen, die jeweils mit einem jeweiligen programmierbaren Logikblock in jeder ersten und zweiten Reihe verbunden sind.

4. Programmierbare Logikanordnung nach Anspruch 1, 2 oder 3, umfassend Verbindungsleitungen zwischen den genannten ersten Mitteln (24a ... 24c) und den genannten dritten Reihen (26a ... 26c).

5. Programmierbare Logikanordnung nach Anspruch 1, 2, 3 oder 4, bei der die zweiten Reihen (32a ... 32c) zu jeweiligen Teilmengen organisiert sind, wobei die jeweiligen Logikkombinationen jeweils eine logische ODER-Verknüpfung eines jeweiligen Ausgangs der dritten Mittel und einer jeweiligen einen der Teilmengen sind.

## Revendications

1. Dispositif logique programmable comprenant
un premier réseau avec des premières rangées (22a .. 22c) de premiers blocs logiques programmables;
des premiers moyens (24a .. 24c) pour former un ET logique respectif des sorties des premiers blocs logiques programmables dans chaque première rangée respective;
un deuxième réseau avec des deuxièmes rangées (32a .. 32c) de deuxièmes blocs logiques programmables, les deuxièmes rangées (32a .. 32c) disposées parallèles aux premières rangées (22a .. 22c);
des deuxièmes moyens (34a .. 34c) pour former un ET logique respectif des sorties des deuxièmes blocs logiques programmables dans chaque deuxième rangée respective;
des troisièmes rangées (26a .. 26c) de troisièmes blocs logiques programmables, les troisièmes rangées étant situées dans le premier réseau parmi les premières rangées (22a .. 22c), chaque troisième bloc logique programmable recevant une sortie respective des premiers moyens;
des troisièmes moyens (38a .. 38c) pour former un OU logique respectif des sorties des troisièmes blocs logiques programmables dans chaque troisième rangée respective;
des moyens logiques (40a .. 40c) pour former des combinaisons logiques respectives de sorties des deuxièmes et troisièmes moyens.

2. Dispositif logique programmable selon la revendication 1, dans lequel lesdits premier et deuxième réseaux sont arrangés dans une zone rectangulaire sur une pastille semi-conductrice, tous les deux le long d'un premier bord de ladite zone rectangulaire, les premières (22a .. 22c), deuxièmes (32a .. 32c) et troisièmes (26a .. 26c) rangées situées perpendiculaires au premier bord.

3. Dispositif logique programmable selon la revendication 1 ou 2, ayant une pluralité de lignes d'entrée, couplées chacune à un bloc logique programmable respectif dans chacune des premières et deuxièmes rangées.

4. Dispositif logique programmable selon la revendication 1,2 ou 3 comprenant des lignes de couplage entre lesdits premiers moyens (24a .. 24c) et lesdites troisièmes rangées (26a .. 26c).

5. Dispositif logique programmable selon la revendication 1,2,3 ou 4, dans lequel les deuxièmes rangées (32a .. 32c) sont organisées en des sous-ensembles respectifs, les combinaisons logiques respectives étant chacune un OU logique d'une sortie respective des troisièmes moyens et un sous-ensemble respectif des sous-ensembles.
